# FASCICULE DE BREVET EUROPEEN

(11) **EP 0 919 914 B1**
(45) Date de publication et mention de la délivrance du brevet: **16.04.2003**
(21) Numéro de dépôt: 98402786.2
(22) Date de dépôt: 10.11.1998
(51) Int. Cl.: G06F 11/00, G06F 12/06

(54) **Architecture pour la gestion de données vitales dans une machine multi-modulaire et procédé pour la mise en oeuvre d'une telle architecture**
Architektur zur Verwaltung vitaler Daten in einem mehrfach modularen Gerät und Verfahren zum Betrieb einer solchen Architektur
Architecture for managing vital data in a multi-modular machine and method for operating such an architecture

(30) Priorité: 27.11.1997 FR 9714899
(43) Date de publication de la demande: 02.06.1999
(73) Titulaire: BULL S.A., 78434 Louveciennes Cedex (FR)
(72) Inventeur: de Bonis-Hamelin, Marie-Antoinette, 38120 Saint Egreve (FR); Menyhart, Zoltan, 38240 Meylan (FR)

(56) Documents cités:
- EP-A- 0 602 772
- EP-A- 0 681 239
- SALIM HARIRI ET AL: "ARCHITECTURAL SUPPORT FOR DESIGNING FAULT-TOLERANT OPEN DISTRIBUTED SYSTEMS" COMPUTER, vol. 25, no. 6, 1 juin 1992, pages 50-61, XP000303775
- BAKER W E ET AL: "A FLEXIBLE SERVERNET-BASED FAULT-TOLERANT ARCHITECTURE" 25TH. INTERNATIONAL SYMPOSIUM ON FAULT TOLERANT COMPUTING DIGEST OF PAPERS, PASADENA, JUNE 27 - 30, 1995, no. SYMP. 25, 27 juin 1995, pages 2-11, XP000597772 INSTITUTE OF ELECTRICAL AND ELECTRONICS ENGINEERS

## Description

La présente invention concerne une architecture pour la gestion de données vitales dans une machine multi-modulaire de traitement de données numérique.

Elle concerne également un procédé de gestion de données vitales pour la mise en oeuvre d'une telle architecture.

Dans le cadre de l'invention, le terme "vital" s'applique à des données essentielles au bon fonctionnement de tout ou partie de la machine, ou de ses modules. De façon plus générale, il s'agit de toutes données que l'utilisateur de la machine désire conserver ou protéger, même en cas de dysfonctionnement d'une partie de cette machine.

Les machines de traitement d'informations numériques dites "multi-modulaires" sont composées à partir de "briques" ou modules de base identiques et interconnectés de façon appropriée pour pouvoir communiquer entre eux.

Dans un but de simplification, les "machines de traitement d'informations numériques multi-modulaires" seront appelées ci-après "machines".

Pour le type de machine précité, une des premières exigences rencontrées est que, même si un module devient défectueux, les données vitales puissent être récupérées.

Dans l'art connu, il existe des machines dites "de haute fiabilité" permettant la protection des données. Elles présentent une grande redondance matérielle. Plusieurs éléments identiques sont reliés entre eux. En d'autres termes, ces machines utilisent des mécanismes matériels pour répliquer les données et assurer leur cohérence.

Si le résultat obtenu est tout à fait conforme à ce que l'on peut attendre de ces dispositions, ces machines présentent cependant un inconvénient majeur : leur coût est élevé, du fait précisément de la redondance en matériel, et leur architecture matérielle est complexe.

Or, dans la plupart des cas, l'utilisation d'une solution coûteuse ne se justifie pas. Tout au contraire, même si une certaine redondance peut rester nécessaire, il s'avère de plus en plus que la réduction du prix de revient (fabrication, matériel utilisé, etc.) est une exigence incontournable. Le prix du matériel a d'ailleurs fortement chuté ces dernières années, alors que les performances des machines ont, pour leur part, fortement augmentées.

L'article de Salim Hariri et al. intitulé "Architectural Support for Designing Fault-Tolerant Open Distributed Systems" et publié dans la revue *Computer,* vol. 25, n° 6, juin 1992, pages 50-61, décrit une architecture de mémoire permanente pour rendre des systèmes ouverts distribués multimodulaires tolérants aux pannes. Chaque module comprend une mémoire semi-conductrice permanente, secourue par une source d'alimentation électrique permanente de manière à conserver les données vitales lorsque le système est mis hors tension ou en cas de panne d'alimentation électrique du système.

L'invention se fixe pour but de pallier les inconvénients des dispositifs de l'art connu, tout en répondant au mieux aux exigences qui se font jour.

Le procédé selon l'invention permet d'assurer l'intégrité des informations vitales.

Elle propose une architecture particulière de machine pour la gestion de données vitales et un procédé de gestion de ces données vitales.

Pour ce faire, on munit chaque module d'une mémoire non-volatile dans laquelle des données vitales sont enregistrées, selon une organisation qui sera précisée ci-après.

Il s'agit d'une mémoire du type connu sous l'abréviation anglosaxonne "NVRAM" (pour "Non-Volatile Random Access Memory"). Ce type de mémoire permet une lecture, mais aussi une écriture rapide de données. Elle est secourue par une alimentation électrique permanente, à piles ou batteries, de sorte qu'elle continue de fonctionner lorsque la machine est hors tension ou en cas de panne secteur. Elle conserve donc les données enregistrées, en l'occurrence les données vitales précitées. Cette mémoire est distincte des autres mémoires : mémoire fixe ("ROM") ou vive ("RAM").

Ces mémoires constituent un ensemble de mémoires non-volatiles locales dites "physiques" et cet ensemble est vu par le système d'exploitation de la machine, ou une extension de celui-ci, comme une mémoire non-volatile à adressage virtuel unique.

Chaque mémoire locale physique comprend deux parties : une première partie emmagasine une copie de données vitales dites "globales", une seconde partie emmagasine des données "privées" locales. Il en est de même de l'espace d'adressage virtuel : une première partie est constituée par ce qui sera appelée une "mémoire non-volatile virtuelle globale", les données vitales globales étant "vues" une seule fois ; une seconde partie est constituée par ce qui sera appelée "mémoire non-volatile virtuelle locale".

Le procédé de gestion comprend deux phases principales : une première phase, au démarrage de la machine, pendant laquelle l'état des modules et de leurs mémoires est vérifié, et une seconde phase, lorsque le système d'exploitation est lancé, pendant laquelle l'accès à la mémoire à adressage virtuel est assuré ainsi que la cohérence des mémoires non-volatiles physiques.

L'invention a donc pour objet une architecture pour la gestion de données vitales, telle que définie par les caractéristiques de la revendication 1.

L'invention a encore pour objet un procédé de gestion de données vitales, tel que défini par les caractéristiques de la revendication 3.

L'invention présente de nombreux avantages et répond bien aux buts qu'elle s'est fixés, car, tout en assurant l'intégrité des données vitales, elle ne nécessite qu'un très faible accroissement de la quantité de matériel utilisé : essentiellement la présence dans chaque module d'une mémoire non-volatile de capacité peu élevée. La redondance *stricto sensu* se limite à la réplication des données dites "globales" dans chaque module.

L'invention sera mieux comprise et d'autres caractéristiques et avantages apparaîtront à la lecture de la description qui suit en référence aux figures annexées, parmi lesquelles:
- la figure 1 illustre de façon simplifiée une architecture de machine de traitement de données numériques multi-modulaire conforme à l'invention ;
- la figure 2 illustre schématiquement une mémoire non-volatile à adressage virtuel permettant un accès à des mémoires non-volatiles physiques comprises dans chaque module de l'architecture de la figure 1 ;
- et la figure 3 illustre schématiquement les différentes couches de logiciel dont est munie la machine de traitement de données numériques multi-modulaire de la figure 1.

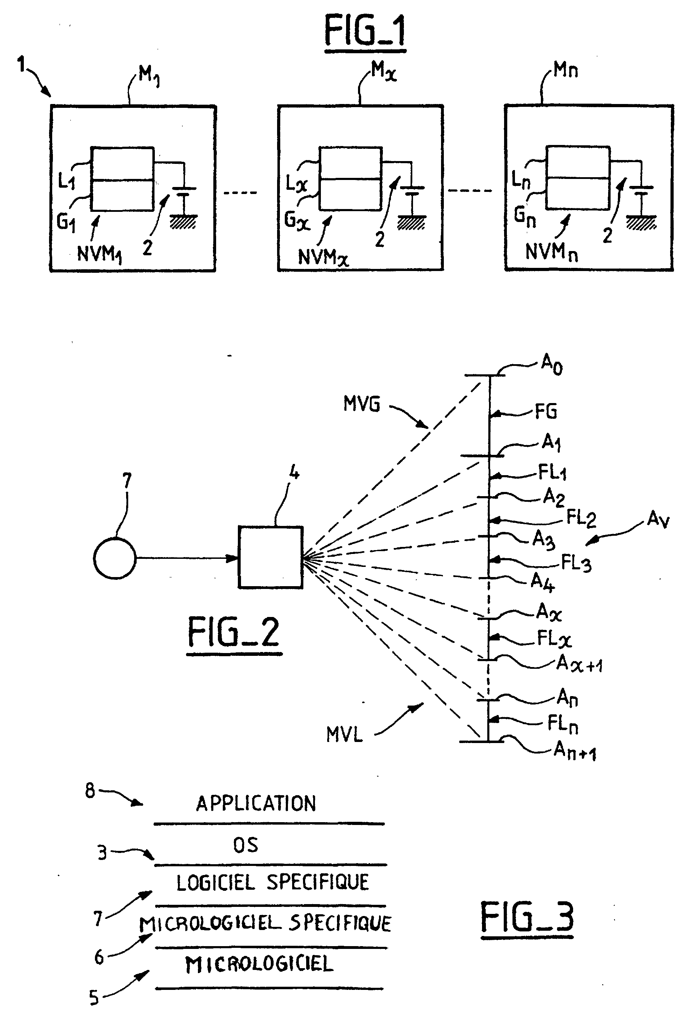

La figure 1 illustre une architecture de machine multi-modulaire 1 conforme à l'invention, pour la gestion des données vitales. La machine 1 comprend n modules, référencés M₁, ..., M_{*x*}, ..., M_{*n*}. Chaque module, outre les organes habituels (non représentés), telle qu'une unité centrale, une mémoire vive, etc., comprend également, conformément à une caractéristique importante de l'invention, une mémoire non-volatile spécifique : NVM₁, ..., NVM_{*x*}, ..., NVM_{*n*}.

Comme il a été indiqué précédemment, il s'agit avantageusement de mémoires de type "NVRAM", secourues par des sources d'alimentation électrique permanente 2, par exemple des piles ou des batteries rechargeables.

Selon une autre caractéristique importante de l'invention, chaque mémoire non volatile, que l'on qualifiera de "physique", puisqu'il s'agit bien d'un circuit matériel, est découpée en deux zones d'emplacements de mémoires, c'est-à-dire des adresses physiques. Une première zone de chaque mémoire non-volatile est affectée à une copie de données vitales globales. Ces zones sont référencées G₁, ..., G_{*x*}, ..., G_{*n*}. Ces données vitales globales sont associées au fonctionnement de la machine considérée dans son ensemble. Une seconde zone de chaque mémoire non-volatile est affectée à l'enregistrement de données privées, locales au module en question. Ces zones sont référencées L₁, ..., L_{*x*}, ..., L_{*n*}. Ces données sont relatives à l'exploitation propre à chaque module.

Les contenus des premières zones, G₁ à G_{*n*}, doivent tous être identiques. Il s'agit d'une copie, ou partie répliquée dans chaque module, M₁ à M_{*n*}, chargée lors d'une phase initiale.

Les données vitales globales consistent, à titre d'exemple non limitatif, en des informations telles que l'adresse réseau de la machine, s'il existe plusieurs connexions possibles, la première adresse réseau, le nom du système, le périphérique à partir duquel on initialise la machine ("boot") et des options associées, etc.

Vu du système d'exploitation, ou plus précisément, comme il le sera montré ci-après, d'une extension spécifique de ce système d'exploitation 7, l'ensemble des mémoires physiques non-volatiles NVM₁ à NVM_{*n*}, constitue un espace d'adressage virtuel unique continu Av, comme illustré par la figure 2. Les octets sont adressables dans une tranche s'étageant d'une adresse A₀ à une adresse A_{*n*}₊₁, l'adresse A₀ étant a priori l'adresse 0. La taille maximale de cet espace mémoire virtuel Av dépend de la configuration maximale de la machine 1, notamment du nombre maximum de modules M₁ à M_{*n*}, et de la quantité de données vitales, locales et globales.

De façon analogue aux mémoires non-volatiles physiques NVM₁ à NVM_{*n*}, la mémoire virtuelle Av comprend également deux parties.

La première partie est constituée par une plage FG, d'adresses A₀ à A₁, permettant l'accès aux données vitales globales. En effet, les données globales ne sont "vues" qu'une seule fois par le système d'exploitation, via son extension 7, puisque seules les données vitales globales sont copiées (dupliquées) dans chaque mémoire locale physique NVM₁ à NVM_{*n*}. Cette partie de la mémoire virtuelle Av sera appelée "mémoire non-volatile virtuelle globale" MVG.

De façon analogue, la seconde partie de la mémoire virtuelle est appelée "mémoire virtuelle non-volatile locale" MVL. Le nombre de "fenêtres" ou tranches élémentaires d'adressage est égal au nombre maximum de modules M₁ à M_{*n*}, que peut comprendre la machine 1, par exemple *n* si la configuration représentée sur la figure 1 est la configuration maximale, un nombre plus grand dans le cas contraire.

Sur la figure 2, les tranches d'adresses sont référencés A₁-A₂, A₂-A₃, A₃-A₄, ..., Aₓ-A_{*x*}₊₁, ..., A_{*n*}-A_{*n*}₊₁, pour les fenêtres correspondant aux données vitales locales, FL₁, FL2, FL₃, ..., FL_{*x*}, ..., FL*n*, respectivement.

Le mécanisme 4 d'affectation d'adresses, dans l'espace virtuel Av est un mécanisme classique, connu *per se,* qu'il n'est pas utile de décrire plus avant.

Il doit être bien entendu par ailleurs que, si la configuration d'adressage illustrée par la figure 2 est avantageuse, elle n'est pas la seule possible. A titre d'exemple, la zone de mémoire virtuelle MVG, correspondant aux données vitales globales pourrait tout aussi bien être localisée en zone d'adresses hautes.

Selon l'invention, si un module quelconque, M_{*x*} (ou pour le moins la mémoire non-volatile physique qui lui est associée, NVM_{*x*}) est défectueux, tombe en panne ou n'existe pas (configuration matérielle réelle de la machine inférieure à la configuration maximale), sa fenêtre d'adressage FL_{*x*}, reste ou devient inaccessible, dans l'espace mémoire virtuel correspondant à la "mémoire non-volatile virtuelle locale" MVL. Dans tous les cas cela signifie que le module en question n'est pas ou plus accessible.

On va maintenant décrire la procédure proprement dite destinée à assurer l'intégrité des données vitales. Selon le procédé de l'invention, cette procédure comprend deux phases principales.

La première phase ou phase initiale est relative à la période de démarrage ou de redémarrage de la machine 1.

La figure 3 illustre de façon schématique les couches de logiciels associées à la machine 1 : des couches profondes, constituées par un micrologiciel ("firmware") standard 5 et un micrologiciel spécifique 6, c'est-à-dire de micro-instructions, deux couches intermédiaires, constituées par un logiciel spécifique 7, appelé "couche d'abstraction" (qui sera décrit ci-après), le système d'exploitation 3, et une couche supérieure constituée par les logiciels 8 d'application ou d'utilisateur.

La couche de micrologiciel 6, dite "spécifique" complète la couche de micrologiciel 5, que l'on peut appeler standard, même si cette dernière est d'un type dit "propriétaire". En effet, que les mécanismes propres à l'invention soient implantés ou non, la seule différence au niveau des couches profondes est constituée par la présence ou non de cette couche de micrologiciel spécifique 6. En d'autres termes, il n'est pas nécessaire de modifier la couche standard 5.

La fonction de la couche de micrologiciel spécifique 6 est de vérifier, au moment du démarrage, c'est-à-dire avant que le système d'exploitation 3 soit lancé, l'état des mémoires non-volatiles physiques NVM₁ à NVM_{*n*}, notamment si les sommes de contrôle des blocs de données sont correctes.

De façon encore plus spécifique à l'invention, le micrologiciel spécifique 6 compare le contenu des premières zones de mémoire, G₁ à G_{*n*}, des mémoires non-volatiles physiques, NMV₁ à NMV_{*n*}, c'est-à-dire les zones afférentes aux données vitales globales, de manière à déterminer si leurs contenus sont identiques.

Si le micrologiciel spécifique 6 trouve des erreurs, c'est-à-dire des discordances, il existe deux modes principaux de correction d'erreurs, comme indiqué ci-dessous.

Pour une option que l'on appellera "à haute disponibilité", on prévoit un mécanisme (non représenté), classique en soi, de vote majoritaire. S'il existe une ou plusieurs mémoires dont le contenu de la première zone (par exemple le contenu de la zone G_{*x*} pour une mémoire MVN_{*x*}, de rang arbitraire *x*) n'est pas conforme à celui obtenu par le vote majoritaire, ou ces mémoire(s) est (sont) déclarée(s) "minoritaire(s)". Elle(s) est (sont) réinitialisée(s) de manière à réécrire le contenu de la première zone (par exemple G_{*x*}, si la seule mémoire défaillante est NMV_{*x*}) et de le rendre conforme à celui obtenu par le vote majoritaire. Cette opération est effectuée sous le contrôle et la commande du micrologiciel spécifique 6.

Il est à noter que ce mode opératoire ne nécessite pas de matériel supplémentaire, c'est-à-dire une redondance matérielle, le vote majoritaire pouvant être réalisé par des opérations logicielles.

Pour une option que l'on appellera "de haute sécurité", le micrologiciel spécifique 6 ne corrige pas automatiquement les erreurs lui-même. L'action réalisée consiste en une simple détection d'un état "erreur détectée", état qui est transmis à un opérateur humain (non représenté) sous la forme d'un message, par exemple visuel (voyant sur une console opérateur, etc.). C'est l'opérateur qui décide alors de la suite à donner à l'incident détecté et effectue manuellement les opérations de correction d'erreur, c'est-à-dire modifie sélectivement le contenu dune ou plusieurs mémoires non-volatiles physiques, NVM₁ à NVM_{*n*}.

Il est clair que ce processus est plus lent que le processus précédent, mais il offre une plus grande sûreté de fonctionnement. En effet, dans le cas d'une seule mémoire déclarée "minoritaire" dans une configuration comprenant un grand nombre de mémoires non-volatiles physiques, il est très probable, selon les lois de la statistique, que ce soit cette mémoire qui soit en erreur. Cependant, cette probabilité diminue fortement, d'une part lorsque le nombre total de modules, donc de mémoires non-volatiles, est faible, d'autre part, lorsque la proportion de mémoires "minoritaires" est proche de celle des mémoires "majoritaires". En d'autres termes, le nombre de mémoires en erreur peut, dans des circonstances a *priori* exceptionnelles, être plus important que celui des mémoires à contenu correct. Dans ces dernières circonstances, le vote majoritaire conduit à une correction erronée du contenu des premières zones G₁ à G_{*n*}, de toutes les mémoires non-volatiles physiques NVM₁ à NVM_{*n*}. Il en résulte que tout ou partie des données vitales globales est alors perdu. La "mémoire non-volatile virtuelle globale" MVG, c'est-à-dire les données vitales globales (fenêtre FG), vues du système d'exploitation 3, est alors également en erreur.

Si une ou plusieurs mémoires en erreur ne peu(ven)t être réinitialisée(s), cela signifie que cette (ces) mémoires (est) sont défectueuse(s). Le ou les module(s) module(s) est (sont) arrêté(s), et la ou les fenêtre(s) est (sont) inaccessible(s) dans l'espace d'adressage virtuel Av de la mémoire virtuelle locale MVL.

Lorsque le système d'exploitation 3 est lancé, c'est-à-dire pendant le régime de fonctionnement normal de la machine 1, se déroule la deuxième phase de la procédure destinée à assurer l'intégrité des données vitales du procédé selon l'invention.

Pour ce faire, une deuxième pièce de logiciel spécifique est mise en oeuvre. Il s'agit d'une couche de logiciel intermédiaire, que l'on appellera "couche d'abstraction" qui prolonge les fonctions du système d'exploitation 3 et assure les interfaces nécessaires avec ce dernier. C'est cette couche, constituant une extension du noyau ("kernel"), qui est en charge de fournir l'accès à la mémoire à adressage virtuelle (figure 2). Elle assure en outre la cohérence parmi les mémoires non-volatiles physiques NMV₁ à NMV_{*n*}.

Ces dispositions permettent de ne pas modifier le système d'exploitation standard de la machine 1, tout en assurant le fonctionnement correct des mémoires physiques non volatiles NMV₁ à NMV_{*n*}, et l'adressage virtuel de ces mémoires, selon le procédé de l'invention.

Le logiciel spécifique 7 assure aussi la surveillance des mémoires physiques non-volatiles NVM₁ à NVM_{*n*}, et l'intégrité des données enregistrées dans ces mémoires.

Pour fixer les idées, si le système d'exploitation 3 est un environnement UNIX (marque déposée) ou similaire, les opérations précitées peuvent s'effectuer sous le contrôle de "demons" qui tournent en permanence.

Lorsqu'une erreur est détectée, selon sa gravité, deux types de mesures peuvent être pris. S'il s'agit d'une erreur fatale, le ou les modules ayant causé l'erreur est (sont) arrêté(s), voire dans certains cas très graves la machine complète. Si un ou plusieurs modules sont arrêtés, conformément à l'invention, leurs fenêtres d'adressage cessent d'être visibles.

Le système d'exploitation 3 est interfacé avec le micrologiciel spécifique 6 qui met à sa disposition une structure de données qui contient, notamment:
- la spécification du nombre maximum de modules (figure 1 : M₁ à Mₙ), c'est-à-dire la configuration maximale de la machine 1) ;
- la description du découpage de l'espace d'adressage de la mémoire virtuelle AV ;
- et des informations suffisantes pour accéder à la couche de logiciel spécifique 7 ou couche dite "d'abstraction" qui permet de lire et écrire la mémoire à adressage virtuel AV.

A la lecture de ce qui précède, on constate aisément que l'invention atteint bien les buts qu'elle s'est fixés.

Il doit être clair cependant que l'invention n'est pas limitée aux seuls exemples de réalisations explicitement décrits, notamment en relation avec les figures 1 à 3.

## Revendications

1. Architecture pour la gestion de données vitales dans une machine (1) multi-modulaire de traitement d'informations numériques, ladite machine comprenant un nombre maximum prédéterminé de modules (M₁-M_{*n*}), chacun desdits modules (M₁-M_{*n*}) comprenant une mémoire non-volatile physique (NVM₁-NVM_{*n*}) à accès aléatoire secourue par une source d'alimentation électrique permanente de manière à conserver lesdites données vitales lorsque ladite machine (1) est mise hors tension ou en cas de panne d'alimentation électrique de cette machine (1), l'architecture étant **caractérisée en ce que** ladite mémoire non-volatile physique (NVM₁-NVM_{*n*}) de chacun desdits modules (M₁-M_{*n*}) est divisée en des première (G₁-G_{*n*}) et seconde (L₁-L_{*n*}) zones de positions de mémoire, **en ce que** ladite première zone (G₁-G_{*n*}) est destinée à l'enregistrement de données vitales globales associées au fonctionnement de la machine (1), ces données étant répliquées d'une mémoire non-volatile physique à l'autre et étant identiques lorsque tous les modules sont dans un état de fonctionnement correct, et **en ce que** ladite seconde zone (L₁-L_{*n*}) est destinée à l'enregistrement de données vitales locales, dites privées, associées au fonctionnement du module particulier (M₁-M_{*n*}) dans lequel est comprise ladite mémoire non-volatile physique locale (NVM₁-NVM_{*n*}).

2. Architecture selon la revendication 1, **caractérisée en ce qu'**elle comprend un organe d'adressage (4) d'un espace continu d'adresses virtuelles (Av), constitué d'une première mémoire non-volatile (MVG) à adressage virtuel rendant accessible lesdites données vitales globales, sous la forme d'un espace d'adressage virtuel unique (FG), et une seconde mémoire non-volatile (MVL) à adressage virtuel, rendant accessibles lesdites données vitales locales, sous la forme d'une série de fenêtres d'adresses virtuelles contiguës (FL₁-FL_{*n*}), les fenêtres étant en nombre égal audit nombre maximum prédéterminé de modules (M₁-M_{*n*}), une fenêtre (FL₁-FL_{*n*}) associée à un module déterminé (M₁-M_{*n*}) n'étant pas accessible lorsque celui-ci est défectueux ou inexistant dans ladite machine (1).

3. Procédé de gestion de données vitales dans une machine (1) multi-modulaire de traitement d'informations numériques, ladite machine comprenant un nombre maximum prédéterminé de modules (M₁-M_{*n*}), chacun desdits modules (M₁-M_{*n*}) comprenant une mémoire non-volatile physique (NVM₁-NVM_{*n*}) à accès aléatoire secourue par une source d'alimentation électrique permanente de manière à conserver lesdites données vitales lorsque ladite machine (1) est mise hors tension ou en cas de panne d'alimentation électrique de cette machine (1), le procédé comprenant une étape initiale de chargement desdites mémoires non-volatiles physiques (NVM₁-NVM_{*n*}) par des données vitales et étant **caractérisé en ce qu'**il comprend en outre le chargement, dans une première zone (G₁-G_{*n*}) de positions de mémoire desdites mémoires non-volatiles physiques (NVM₁-NVM_{*n*}), avec des données vitales globales associées au fonctionnement de ladite machine (1), ces données étant répliquées d'une mémoire non-volatile physique à l'autre et étant identiques lorsque tous les modules sont dans un état de fonctionnement correct, et le chargement, dans une seconde zone (L₁-L_{*n*}) de positions de mémoire desdites mémoires non-volatiles physiques (NVM₁-NVM_{*n*}), avec des données vitales locales, dites privées, associées au fonctionnement du module particulier (M₁-M_{*n*}) dans lequel est comprise ladite mémoire non-volatile physique locale (NVM₁-NVM_{*n*})

4. Procédé selon la revendication 3, **caractérisé en ce qu'**il comprend une étape de formation d'un espace continu d'adresses virtuelles (Av), constitué d'une première mémoire non-volatile (MVG) à adressage virtuel rendant accessible lesdites données vitales globales, sous la forme d'un espace d'adressage virtuel unique (FG), et une seconde mémoire à adressage virtuel (MVL), rendant accessibles lesdites données vitales locales, sous la forme d'une série de fenêtres d'adresses virtuelles contiguës (FL₁ -FL_{*n*}), et une étape de détection des modules défectueux ou inexistants (M₁-M_{*n*}) dans ladite machine (1) rendant inaccessibles, dans l'espace d'adressage virtuel de la mémoire non-volatile virtuelle locale (MVL), les fenêtres d'adresses virtuelles (FL₁-FL_{*n*}) associées aux mémoires non-volatiles physiques (NVM₁-NVM_{*n*}) de ces modules (M₁-M_{*n*}).

5. Procédé selon la revendication 4, **caractérisé en ce qu'**il comprend une phase initiale consistant, lors du démarrage de ladite machine (1), à vérifier le bon fonctionnement desdites mémoires non-volatiles physiques (NVM₁-NVM_{*n*}), de manière à détecter lesdits modules défectueux (M₁-M_{*n*}).

6. Procédé selon la revendication 5, **caractérisé en ce que** ladite phase initiale comprend une étape consistant à comparer le contenu desdites premières zones d'adresses (G₁-G_{*n*}) de toutes les mémoires non-volatiles physiques (NVM₁-NVM_{*n*}) existantes de ladite machine (1) et à générer une condition d'erreur en cas de détection d'au moins une divergence.

7. Procédé selon la revendication 6, **caractérisé en ce que**, lors d'une détection d'erreur, un vote majoritaire entre les contenus desdites premières zones (G₁-G_{*n*}) de toutes les mémoires non-volatiles physiques (NVM₁-NVM_{*n*}) est effectué, et **en ce que**, suite audit vote, le contenu des premières zones d'adresses des mémoires minoritaires est ré-initialisé en y chargeant le contenu des premières zones d'adresses des mémoires majoritaires, de manière à supprimer ladite condition d'erreur.

8. Procédé selon la revendication 6 ou 7, **caractérisé en ce que** ladite phase initiale se déroule sous la commande d'un micrologiciel spécifique (6).

9. Procédé selon la revendication 4, **caractérisé en ce qu'**il comprend une deuxième phase consistant, lorsque le système d'exploitation (3) dont est munie ladite machine (1) est lancé, à scruter l'état desdites mémoires non-volatiles physiques (NVM₁-NVM_{*n*}) et à détecter l'apparition de pannes dans le fonctionnement desdits modules (M₁-M_{*n*}).

10. Procédé selon la revendication 9, **caractérisé en ce que** ladite deuxième phase se déroule sous la commande d'un logiciel spécifique (7), formant extension dudit système d'exploitation (3), et **en ce que** ce logiciel spécifique (7) assure l'accès à ladite mémoire non-volatile virtuelle (Av) et la cohérence entre les contenus desdites premières zones (G₁-G_{*n*}) de toutes les mémoires non-volatiles physiques (NVM₁-NVM_{*n*}).

11. Procédé selon les revendications 8 et 10, **caractérisé en ce que** ledit micrologiciel spécifique (6) est interfacé avec le système d'exploitation (3) de ladite machine (1) et **en ce qu'**il comporte une liste de données accessibles par ledit système d'exploitation (3) contenant, au moins, des informations sur ledit nombre maximum prédéterminé de modules (M₁-M_{*n*}), des informations sur le découpage dudit espace d'adressage virtuel de ladite mémoire non-volatile virtuelle (Av) et des informations permettant au système d'exploitation (3) d'accéder audit logiciel spécifique (7), de manière à autoriser des opérations de lecture et d'écriture dans ladite mémoire non-volatile virtuelle (Av).

## Claims

1. Architecture for managing vital data in a multi-modular machine (1) for processing digital information, said machine comprising a predetermined maximum number of modules (M₁-M_{*n*}), each of said modules (M₁-M_{*n*}) comprising a physical non-volatile random access memory (NVM₁-NVM_{*n*}) backed up by a permanent electric power source so as to preserve said vital data when said machine (1) is switched off or in the event of an electric power failure for that machine (1), the architecture being **characterised in that** said physical non-volatile memory (NVM₁-NVM_{*n*}) of each of said modules (M₁-M_{*n*}) is divided into first (G₁-G_{*n*}) and second (L₁-L_{*n*}) memory location zones, **in that** said first zone (G₁-G_{*n*}) is intended for the recording of global vital data associated with the operation of the machine (1), these data being replicated from one physical non-volatile memory to another and being identical when all the modules are in a correct operational state, and **in that** said second zone (L₁-L_{*n*}) is intended for the recording of local vital data, referred to as private, associated with the operation of the particular module (M₁-M_{*n*}) in which is comprised said local physical non-volatile memory (NVM₁-NVM_{*n*}).

2. Architecture according to Claim 1, **characterised in that** it comprises a unit (4) for addressing a continuous virtual address space (Av) constituted by a first non-volatile memory (MVG) with virtual addressing making said global vital data accessible, in the form of a single virtual addressing space (FG), and a second non-volatile memory (MVL) with virtual addressing, making said local vital data accessible, in the form of a series of contiguous virtual address windows (FL₁-FL_{*n*}), the windows being equal in number to said predetermined maximum number of modules (M₁-M_{*n*}), a window (FL₁-FL_{*n*}) associated with a given module (M₁-M_{*n*}) not being accessible when said module is defective or non-existent in said machine (1).

3. Method for managing vital data in a multi-modular machine (1) for processing digital information, said machine comprising a predetermined maximum number of modules (M₁-M_{*n*}), each of said modules (M₁-M_{*n*}) comprising a physical non-volatile random access memory (NVM₁-NVM_{*n*}) backed up by a permanent electric power source so as to preserve said vital data when said machine (1) is switched off or in the event of a failure of electric power for that machine (1), the method comprising an initial step of loading said physical non-volatile memories (NVM₁-NVM_{*n*}) with vital data and being **characterised in that** it further comprises the loading, into a first memory location zone (G₁-G_{*n*}), of said physical non-volatile memories (NVM₁-NVM_{*n*}), with global vital data associated with the operation of said machine (1), these data being replicated from one physical non-volatile memory to another and being identical when all the modules are in a correct operational state, and the loading, into a second memory location zone (L₁-L_{*n*}), of said physical non-volatile memories (NVM₁-NVM_{*n*}), with local vital data, referred to as private, associated with the operation of the particular module (M₁-M_{*n*}) in which is comprised said local physical non-volatile memory (NVM₁-NVM_{*n*}).

4. Method according to Claim 3, **characterised in that** it comprises a step of forming a continuous virtual address space (Av), constituted by a first non-volatile memory (MVG) with virtual addressing making said global vital data accessible, in the form of a single virtual addressing space (FG), and a second memory (MVL) with virtual addressing, making said local vital data accessible, in the form of a series of contiguous virtual address windows (FL₁-FL_{*n*}), and a step of detecting defective or non-existent modules (M₁-M_{*n*}) in said machine (1) making the virtual address windows (FL₁-FL_{*n*}) associated with the physical non-volatile memories (NVM₁-NVM_{*n*}) of these modules (M₁-M_{*n*}) inaccessible in the virtual addressing space of the local virtual non-volatile memory (MVL).

5. Method according to Claim 4, **characterised in that** it comprises an initial phase consisting, on start-up of said machine (1), in checking the correct functioning of said physical non-volatile memories (NVM₁-NVM_{*n*}), so as to detect said defective modules (M₁-M_{*n*}).

6. Method according to Claim 5, **characterised in that** said initial phase comprises a step consisting in comparing the content of said first address zones (G₁-G_{*n*}) of all the existing physical non-volatile memories (NVM₁-NVM_{*n*}) of said machine (1) and in generating an error condition in the event that at least one discrepancy is detected.

7. Method according to Claim 6, **characterised in that**, on detection of an error, a majority vote among the contents of said first zones (G₁-G_{*n*}) of all the physical non-volatile memories (NVM₁-NVM_{*n*}) is performed, and **in that**, following said vote, the content of the first address zones of the minority memories is reinitialised by loading into them the content of the first address zones of the majority memories, so as to eliminate said error condition.

8. Method according to Claim 6 or 7, **characterised in that** said initial phase takes place under the control of a specific piece of firmware (6).

9. Method according to Claim 4, **characterised in that** it comprises a second phase consisting, when the operating system (3) with which said machine (1) is provided is started up, in scanning the state of said physical non-volatile memories (NVM₁-NVM_{*n*}) and in detecting the occurrence of malfunctions in the operation of said modules (M₁-M_{*n*}).

10. Method according to Claim 9, **characterised in that** said second phase takes place under the control of a specific piece of software (7), forming an extension to said operating system (3), and **in that** this specific software (7) provides access to said virtual non-volatile memory (Av) and ensures consistency among the contents of said first zones (G₁-G_{*n*}) of all the physical non-volatile memories (NVM₁-NVM_{*n*}).

11. Method according to Claims 8 and 10, **characterised in that** said specific firmware (6) is interfaced with the operating system (3) of said machine (1) and **in that** it has a list of data that are accessible by said operating system (3) containing, at least, information on said predetermined maximum number of modules (M₁-M_{*n*}), information on the partitioning of said virtual addressing space of said virtual non-volatile memory (Av) and information allowing the operating system (3) to access said specific software (7), so as to permit operations of reading from and writing to said virtual non-volatile memory (Av).

## Patentansprüche

1. Architektur für das Management essentieller Daten in einer multimodularen digitalen Datenverarbeitungsmaschine (1), wobei die Maschine eine vorgegebene Höchstanzahl von Modulen (M₁-Mₙ) umfaßt, wovon jedes (M₁-Mₙ) einen nichtflüchtigen physikalischen Speicher (NVM₁-NVMₙ) mit wahlfreiem Zugriff umfaßt, der von einer permanenten Stromversorgungsquelle unterhalten wird, um die essentiellen Daten beizubehalten, wenn die Maschine (1) spannungslos ist oder die Stromversorgung dieser Maschine (1) ausfällt, wobei die Architektur **dadurch gekennzeichnet ist, daß** der nichtflüchtige physikalische Speicher (NVM₁-NVMₙ) jedes der Module (M₁-Mₙ) in erste (G₁-Gₙ) und zweite (L₁-Lₙ) Zonen von Speicherplätzen unterteilt ist, daß die erste Zone (Gₙ-Gₙ) für die Aufzeichnung globaler essentieller Daten bestimmt ist, die dem Betrieb der Maschine (1) zugeordnet sind, wobei diese Daten von einem nichtflüchtigen physikalischen Speicher zum nächsten kopiert werden und gleich sind, wenn sich alle diese Module in einem korrekten Betriebszustand befinden, und daß die zweite Zone (L₁-Lₙ) für die Aufzeichnung lokaler, essentieller, sogenannter privater Daten bestimmt ist, die dem Betrieb des besonderen Moduls (M₁-Mₙ) zugeordnet sind, in dem der lokale nichtflüchtige physikalische Speicher (NVM₁-NVMₙ) enthalten ist.

2. Architektur nach Anspruch 1, **dadurch gekennzeichnet, daß** sie ein Adressierungsorgan (4) für einen ununterbrochenen Raum virtueller Adressen (Av) umfaßt, das aus einem ersten nichtflüchtigen Speicher (MVG) mit virtueller Adressierung, die die globalen essentiellen Daten in Form eines einzigen virtuellen Adressierungsraums (FG) zugänglich macht, sowie aus einem zweiten nichtflüchtigen Speicher (MVL) mit virtueller Adressierung, die die lokalen essentiellen Daten in Form einer Reihe von Fenstern (FL₁-FLₙ) aneinandergrenzender virtueller Adressen zugänglich macht, gebildet ist, wobei die Anzahl der Fenster gleich der vorgegebenen Höchstzahl von Modulen (M₁-Mₙ) ist, wobei ein Fenster (FL₁-FLₙ) einem bestimmten Modul (M₁-Mₙ) zugeordnet ist, auf das nicht zugegriffen werden kann, wenn es fehlerhaft ist oder in der Maschine (1) nicht vorhanden ist.

3. Verfahren für das Management essentieller Daten in einer multimodularen digitalen Datenverarbeitungsmaschine (1), wobei die Maschine eine vorgegebene Höchstzahl von Modulen (M₁-Mₙ) besitzt, wobei jedes der Module (M₁-Mₙ) einen nichtflüchtigen physikalischen Speicher (NVM₁-NVMₙ) mit wahlfreiem Zugriff umfaßt, der von einer permanenten Stromversorgungsquelle unterhalten wird, um die essentiellen Daten beizubehalten, wenn die Maschine (1) spannungslos ist oder wenn die Stromversorgung dieser Maschine (1) ausfällt, wobei das Verfahren einen anfänglichen Schritt umfaßt, bei dem die physikalischen nichtflüchtigen Speicher (NVM₁-NVMₙ) mit essentiellen Daten geladen werden, **dadurch gekennzeichnet, daß** es außerdem das Laden von globalen essentiellen Daten, die dem Betrieb der Maschine (1) zugeordnet sind, in. eine erste Zone (G₁-Gₙ) von Speicherplätzen der nichtflüchtigen physikalischen Speicher (NVM₁-NVMₙ) umfaßt, wobei diese Daten von einem nichtflüchtigen physikalischen Speicher zum nächsten kopiert werden und gleich sind, wenn sich alle diese Module in einem korrekten Betriebszustand befinden, und das Laden von lokalen essentiellen, sogenannten privaten Daten, die dem Betrieb des besonderen Moduls (M₁-Mₙ) zugeordnet sind, in dem sich der lokale physikalische nichtflüchtige Speicher (NVM₁-NVMₙ) befindet, in eine zweite Zone (L₁-Lₙ) von Speicherplätzen der nichtflüchtigen physikalischen Speicher (NVM₁-NVMₙ) umfaßt.

4. Verfahren nach Anspruch 3, **dadurch gekennzeichnet, daß** es umfaßt: einen Schritt, bei dem ein ununterbrochener Raum virtueller Adressen (Av) gebildet wird, der aus einem ersten nichtflüchtigen Speicher (MVG) mit virtueller Adressierung, die in Form eines einzigen virtuellen Adressierungsraums (FG) die globalen essentiellen Daten zugänglich macht, und aus einem zweiten Speicher (MVL) mit virtueller Adressierung, die in Form einer Reihe von Fenstern (FL₁-FLₙ) mit aneinandergrenzenden virtuellen Adressen die lokalen essentiellen Daten zugänglich macht, gebildet ist, sowie einen Schritt, bei dem fehlerhafte oder in der Maschine (1) nicht vorhandene Module (M₁-Mₙ) erfaßt werden und die Fenster (FL₁-FLₙ) virtueller Adressen, die den nichtflüchtigen physikalischen Speichern (NVM₁-NVMₙ) dieser Module (M₁-Mₙ) zugeordnet sind, in dem virtuellen Adressierungsraum des lokalen virtuellen nichtflüchtigen Speichers unzugänglich gemacht werden.

5. Verfahren nach Anspruch 4, **dadurch gekennzeichnet, daß** es eine anfängliche Phase umfaßt, die beim Starten der Maschine (1) darin besteht, den korrekten Betrieb der physikalischen nichtflüchtigen Speicher (NVM₁-NVMₙ) zu verifizieren, derart, daß die fehlerhaften Module (M₁-Mₙ) erfaßt werden.

6. Verfahren nach Anspruch 5, **dadurch gekennzeichnet, daß** die anfängliche Phase einen Schritt umfaßt, der darin besteht, den Inhalt der ersten Adressenzonen (G₁-Gₙ) aller in der Maschine (1) vorhandenen physikalischen nichtflüchtigen Speicher (NVM₁-NVMₙ) zu vergleichen und einen Fehlerzustand im Fall der Erfassung wenigstens einer Abweichung zu erzeugen.

7. Verfahren nach Anspruch 6, **dadurch gekennzeichnet, daß** bei einer Fehlererfassung ein Mehrheitsvotum zwischen den Inhalten der ersten Zonen (G₁-Gₙ) aller physikalischer nichtflüchtiger Speicher (NVM₁-NVMₙ) ausgeführt wird und daß anschließend an das Votum der Inhalt der ersten Zonen von Adressen der Minderheiten-Speicher neu initialisiert wird, indem der Inhalt der ersten Zonen von Adressen der Mehrheits-Speicher in sie geladen wird, um den Fehlerzustand zu beseitigen.

8. Verfahren nach Anspruch 6 oder 7, **dadurch gekennzeichnet, daß** die anfängliche Phase unter der Steuerung einer spezifischen Mikrosoftware (6) erfolgt.

9. Verfahren nach Anspruch 4, **dadurch gekennzeichnet, daß** es eine zweite Phase umfaßt, die beim Start des Betriebssystems (3), mit dem die Maschine (1) versehen ist, darin besteht, den Zustand der physikalischen nichtflüchtigen Speicher (NVM₁-NVMₙ) zu prüfen und das Auftreten von Fehlern im Betrieb der Module (M₁-Mₙ) zu erfassen.

10. Verfahren nach Anspruch 9, **dadurch gekennzeichnet, daß** die zweite Phase unter der Steuerung einer spezifischen Software (7) erfolgt, die eine Erweiterung des Betriebssystems (3) bildet, und daß diese spezifische Software (7) den Zugriff auf den virtuellen nichtflüchtigen Speicher (Av) und die Kohärenz zwischen den Inhalten der ersten Zonen (G₁-Gₙ) aller physikalischen nichtflüchtigen Speicher (NVM₁-NVMₙ) gewährleistet.

11. Verfahren nach den Ansprüchen 8 und 10, **dadurch gekennzeichnet, daß** die spezifische Mikrosoftware (6) über eine Schnittstelle mit dem Betriebssystem (3) der Maschine (1) in Verbindung steht und daß sie eine Liste von Daten umfaßt, auf die das Betriebssystem (3) zugreifen kann und die wenigstens Informationen über die vorgegebene Höchstzahl von Modulen (M₁-Mₙ), Informationen über die Segmentierung des virtuellen Adressierungsraums des virtuellen nichtflüchtigen Speichers (Av) sowie Informationen, die dem Betriebssystem (3) ermöglichen, auf die spezifische Software (7) zuzugreifen, um Lese- und Schreiboperationen in dem virtuellen nichtflüchtigen Speicher (Av) zuzulassen, enthält.
